Europäisches Patentamt

European Patent Office

Office européen des brevets

(19)

(11)  EP 0 685 848 B1

(12)  FASCICULE DE BREVET EUROPEEN

(45) Date de publication et mention
de la délivrance du brevet:
**05.04.2000   Bulletin 2000/14**

(51) Int Cl.$^7$: **G11C 8/00**

(21) Numéro de dépôt: **95401250.6**

(22) Date de dépôt: **30.05.1995**

(54) **Dispositif de détection de transition engendrant une impulsion de durée variable**

Umwandlungsdetektorgerät zur Erzeugung eines Pulses mit variabler Zeitdauer

Transition detection device generating a variable duration pulse

(84) Etats contractants désignés:
**DE GB IT NL**

(30) Priorité:  **01.06.1994   FR 9406694**

(43) Date de publication de la demande:
**06.12.1995   Bulletin 1995/49**

(73) Titulaire: **MHS**
**44087 Nantes Cédex 03 (FR)**

(72) Inventeurs:
• **Bion, Thierry**
**F-44300 Nantes (FR)**

• **Danckaert, Jean-Yves**
**F-44240 La Chapelle sur Erdre (FR)**

(74) Mandataire: **Fréchède, Michel et al**
**Cabinet Plasseraud**
**84, rue d'Amsterdam**
**F-75440 Paris Cédex 09 (FR)**

(56) Documents cités:
**WO-A-87/00340**

**Description**

L'invention concerne un dispositif de détection de transition engendrant une impulsion de durée variable.

Lors de la mise en oeuvre des circuits d'entrée d'un circuit mémoire statique CMOS, un signal de validation, désigné par "*chip enable*", CEB, permet de contrôler l'accès à ces circuits d'entrée.

Lors d'un contrôle d'accès au moyen du signal de validation, CEB, il est nécessaire d'inhiber les impulsions engendrées par les autres entrées du circuit d'entrée, afin d'éviter l'apparition d'impulsions multiples ou rallongées.

A ce titre, le document WO-A-8700340 publié le 15 janvier 1987 décrit un dispositif ayant pour objet de supprimer l'apparition d'un délai associé à l'existence supposée d'une fausse transition par suppression de la détection de transition pendant une durée déterminée grâce à un retard fixe et à des portes logiques NOR, OR et NON-ET.

La présente invention a pour objet la mise en oeuvre d'un dispositif de détection de transition permettant d'engendrer une impulsion de durée variable, et d'inhiber les impulsions engendrées par les autres entrées du circuit d'entrée.

Le dispositif de détection de transition engendrant une impulsion de durée variable, impulsion telle qu'un signal de validation (CEB) des circuits d'entrée d'un circuit mémoire statique CMOS, objet de la présente invention, ces circuits d'entrée délivrant, sur validation, un signal d'entrée à partir d'un signal représentatif d'un signal numérique d'entrée à mémoriser par la mémoire statique, est remarquable en ce qu'il comporte un premier circuit de retard d'une première valeur de retard déterminée du signal de validation, permettant d'engendrer un signal de validation retardé et d'introduire un délai de sécurité d'une durée égale à la première valeur de retard. Un circuit de calibration du signal d'entrée est prévu, lequel comprend un circuit logique OU exclusif recevant sur une première entrée le signal d'entrée et un deuxième circuit de retard commandé en durée par le signal de validation reçoit ledit signal d'entrée et délivre un signal d'entrée retardé d'une deuxième valeur de retard. Le deuxième circuit de retard commandé est connecté à une deuxième entrée du circuit logique OU exclusif, lequel délivre un signal de sortie calibré formé par une impulsion dont la durée est égale à la deuxième valeur de retard lors d'un accès par le signal de validation et des impulsions tronquées en présence de transitions d'adresses ou d'autres entrées non rigoureusement simultanées.

Le dispositif, objet de la présente invention, trouve application à la réalisation et la mise en oeuvre de circuits de mémoire statique de type CMOS.

Il sera mieux compris à la lecture de la description et à l'observation des dessins ci-après dans lesquels :

- la figure 1a représente un schéma synoptique du dispositif de détection de transition, objet de la présente invention ;
- la figure 1b représente un chronogramme des signaux aux points de tests de la figure 1a ;
- la figure 2 représente un détail de réalisation avantageux non limitatif du dispositif représenté en figure 1a.

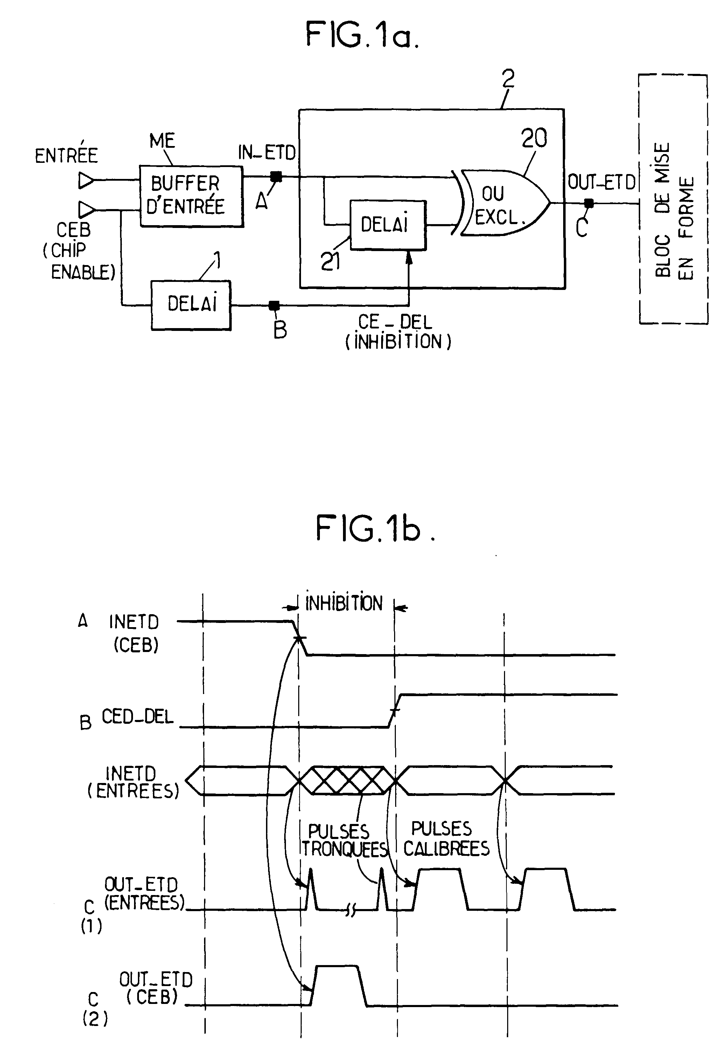

Une description plus détaillée d'un dispositif de détection de transition engendrant une impulsion de durée variable, objet de la présente invention, sera maintenant donnée en liaison avec la figure 1a.

Sur la figure précitée, on a représenté un signal d'entrée représentatif d'un signal numérique d'entrée codé sur une pluralité N de bits, N = 8 par exemple.

Le signal numérique d'entrée, désigné par ENTREE, doit être interprété par une mémoire statique par l'intermédiaire d'un bloc de mise en forme, représenté en pointillés sur la figure 1a. En ce qui concerne la figure précitée, on indique que celle-ci est relative au schéma synoptique d'un circuit permettant le traitement d'un des bits du signal numérique d'entrée. A ce titre, on comprend, conformément à un aspect du dispositif de détection de transition engendrant une impulsion de durée variable, objet de la présente invention, qu'un circuit comparable est présent et opérationnel dans des conditions identiques pour chacun des bits constitutifs du signal numérique d'entrée.

Le signal numérique d'entrée précité, et en particulier l'un des bits de celui-ci, représenté par le signal ENTREE, est normalement mémorisé au niveau d'un circuit d'adaptation d'entrée désigné par circuit "buffer d'entrée", un tel circuit comportant en outre un signal de validation du circuit d'adaptation d'entrée, ce circuit portant la référence ME sur la figure 1a.

Dans les dispositifs actuels, la sortie du circuit d'adaptation d'entrée ME est reliée à un bloc de mise en forme des signaux du circuit, représenté en pointillés sur la figure 1a précitée.

Selon un aspect particulièrement avantageux du dispositif de détection de transition engendrant une impulsion de durée variable, objet de l'invention, cette transition est telle que le circuit d'adaptation d'entrée ME, en présence du signal de validation CEB, délivre de manière classique en sortie du circuit d'adaptation d'entrée ME un signal, noté IN-ETD, lequel est normalement destiné à être interprété par la mémoire statique.

Selon un autre aspect particulièrement avantageux du dispositif de détection, objet de la présente invention, on comprend que celui-ci comprend un premier circuit de retard, noté 1, d'une première valeur de retard déterminée du signal de validation CEB, ce signal correspondant à la désignation anglo-saxonne "Chip enable" et ayant pour effet d'autoriser l'accès au circuit. Le premier circuit de retard 1 permet d'engendrer un signal de validation retardé, noté CE-DEL, tout en permettant d'introduire un délai de sécurité de durée égale à la première valeur de retard, c'est-à-dire à la valeur de retard introduite par le premier circuit de retard 1.

En outre, le dispositif de détection de transition, objet de la présente invention, comporte un circuit de calibration 2 du signal d'entrée à mémoriser, noté IN-ETD, ce circuit de calibration comportant un circuit logique OU exclusif, noté 20, recevant sur une première entrée le signal d'entrée à interpréter, et un deuxième circuit de retard commandé, noté 21, recevant le signal d'entrée à détecter précité et délivrant un signal d'entrée retardé d'une deuxième valeur de retard. On note que le deuxième circuit de retard commandé 21 est connecté à une deuxième entrée du circuit logique OU exclusif, lequel délivre, sur commande d'accès par le signal de validation CEB, un signal de sortie calibré, formé par une impulsion dont la durée est égale à la deuxième valeur de retard, c'est-à-dire à la valeur de retard du deuxième circuit de retard 21. Au contraire, et toujours lors d'un accès par le signal de validation CEB, mais en présence de transitions sur les autres entrées du circuit, le circuit OU exclusif 20 délivre une suite d'impulsions tronquées, non reconnues comme impulsion, ainsi qu'il sera décrit ultérieurement dans la description. Le circuit de calibration 2 du signal d'entrée à mémoriser délivre un signal de sortie, noté OUT-ETD, lequel est délivré au bloc de mise en forme, représenté en traits mixtes sur la figure 1a, et est constitué soit par des impulsions tronquées, soit par l'impulsion calibrée.

Sur la figure 1b, on a représenté les différents signaux aux points de tests A, B, C de la figure 1a. En outre, on rappelle que le signal d'entrée, noté ENTREE, correspond à la valeur de l'ensemble des bits sur lequel est codé ce signal, une modification d'une des valeurs de ces bits étant représentée sur la figure 1b de manière générale sans référence aux points de tests A, B, C. Cette modification est réputée intervenir au point de test A de la figure 1a, c'est-à-dire pour le bit considéré, mis en forme par le circuit d'adaptation d'entrée ME et engendrant le signal numérique d'entrée IN-ETD destiné à être interprété par la mémoire statique.

Sur transition du signal numérique d'entrée à détecter IN-ETD au point de test A, et lors d'un accès par le signal de validation CEB, le signal de validation retardé CE-DEL au point B reste à la valeur 0, et l'inhibition se produit tant que le signal de validation retardé reste à la valeur 0 précitée. Le circuit de calibration 2 délivre pendant le temps d'inhibition des impulsions tronquées, dont la durée est inférieure ou égale à une nanoseconde par exemple, pour toute transition provoquée par un accès adresse, ces impulsions tronquées n'étant alors pas reconnues comme telles par le circuit bloc de mise en forme. La forme correspondante du signal est représentée en C(1) au point de test C.

Au contraire, le signal de validation CEB étant actif, pour le circuit d'entrée pour lequel un accès imposé par le signal de validation CEB est réalisé, les accès d'adresses étant ainsi masqués, le signal délivré par le circuit de calibration 2 associé à ce circuit d'entrée au point de test C correspond à un signal de sortie calibré formé par une impulsion dont la durée est égale à la deuxième valeur de retard du circuit de retard 21. Ce signal est représenté en C(2) sur la figure 1b.

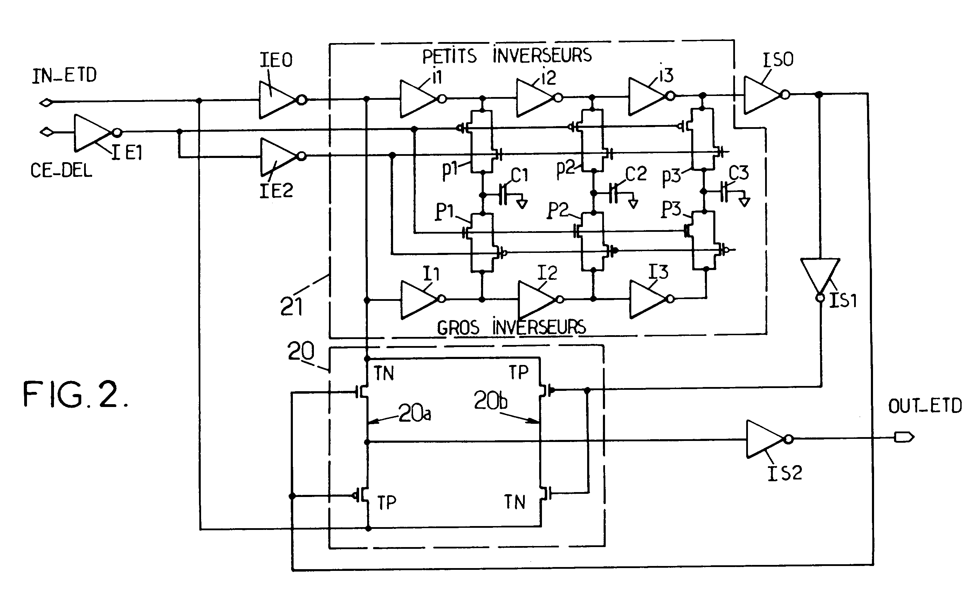

Une description plus détaillée d'un mode de réalisation avantageux du deuxième circuit de retard 21 sera maintenant donnée en liaison avec la figure 2. D'une manière générale, on indique que le deuxième circuit de retard 21, circuit de retard commandé, est formé par une pluralité de cellules de retard connectées en cascade. Sur la figure 2, on indique que trois cellules de retard uniquement sont représentées à titre d'exemple.

Chaque cellule de retard comporte au moins un inverseur, noté i1, i2, i3, connecté à une porte de transfert, notée p1, p2, p3, elle-même connectée à une capacité électrique reliée à la tension de référence, chaque capacité électrique étant notée C1, C2, C3.

Chaque porte de transfert p1, p2, p3 est commandée à l'état de conduction ou de non-conduction par le signal de validation retardé CE-DEL. Ainsi, chaque cellule permet d'introduire, sur le signal d'entrée à mémoriser IN-ETD, un retard élémentaire, noté T, lequel est égal à la constante de temps formée par le circuit de charge de la capacité électrique correspondante C1, C2, C3. Dans le mode de réalisation de la figure 2, on indique que les cellules de retard reçoivent le signal d'entrée complémenté, noté $\overline{\text{IN-ETD}}$, par l'intermédiaire d'un inverseur d'entrée, noté IE0.

De manière classique, on indique que chaque porte de transfert p1, p2, p3 peut être formée par un premier et un deuxième transistor MOS de type P respectivement N connectés en parallèle, l'électrode de grille du premier transistor MOS P étant commandée par le signal de validation retardé complémenté $\overline{\text{CE-DEL}}$ par l'intermédiaire d'un inverseur d'entrée IE1 alors que l'électrode de grille du deuxième transistor MOS N est commandée par le signal de validation retardé CE-DEL obtenu à partir du signal de commande des électrodes de grille des transistors MOS de type P après nouvelle complémentation par un inverseur d'entrée IE2.

En ce qui concerne le circuit OU exclusif 20, on indique que celui-ci peut être formé, dans une version intégrable, par une première et une deuxième branche, notées 20a, 20b, chaque branche étant formée par un transistor MOS N et un transistor MOS P, notés TN, TP pour chacune des branches, les transistors précités étant montés en cascade et les deux branches 20a, 20b étant connectées en parallèle entre l'entrée de la première cellule de retard, c'est-à-dire en fait l'entrée du premier inverseur i1, cellule de retard recevant le signal d'entrée complémenté $\overline{\text{IN-ETD}}$ par l'intermédiaire de l'inverseur d'entrée IE0, et la sortie du circuit de mémorisation d'entrée ME, c'est-à-dire l'entrée de ce même inverseur d'entrée IE0. Les électrodes de grille des transistors MOS TN, respectivement TP de la première branche 20a sont connectées à la sortie de la dernière cellule de retard, c'est-à-dire en fait à la sortie de l'inverseur i3 par l'intermédiaire d'un inverseur de sortie, noté IS0. Les électrodes de grille des transistors TP, TN de la deuxième branche 20b sont connectées à la sortie du premier inverseur de sortie IS0 par l'intermédiaire d'un deuxième inverseur de sortie, noté IS1. Le point commun entre les transistors TN, TP de la première branche 20a délivre par l'intermédiaire d'un troisième inverseur de sortie, noté IS2, le signal de sortie impulsion calibrée ou impulsions tronquées, noté OUT-ETD.

Le fonctionnement du dispositif tel que représenté en figure 2 est le suivant :

Le signal de validation CEB est complémenté et retardé en interne de la valeur du premier retard, par exemple par le premier circuit de retard 1 d'une valeur de 5 nanosecondes, pour engendrer au point de test B le signal de validation retardé, noté CE-DEL, ce signal étant commun à chacun des dispositifs tels que représentés en figure 1a associés à un bit du signal numérique d'entrée.

Lors d'un accès à la mémoire statique par l'intermédiaire du signal de validation CEB, ce signal étant actif lorsqu'il est à la valeur 0, le signal de validation retardé CE-DEL a pour effet de déconnecter, pour une durée égale au retard interne précité, les capacités C1, C2, C3 de la sortie de leurs inverseurs associés i1, i2, i3. Le délai assurant la calibration de la largeur de l'impulsion n'est plus fourni que par les seuls inverseurs i1, i2, i3 précités et se trouve en conséquence drastiquement réduit à une valeur inférieure ou égale à une nanoseconde. Ainsi, toute transition du signal d'entrée survenant dans la plage de temps comprise entre les transitions respectives des signaux de validation CEB et de validation retardée CE-DEL provoque donc la création d'une impulsion tronquée, ainsi que mentionné précédemment.

Contrairement aux autres signaux d'entrée, le dispositif de détection de transition tel que représenté en figure 1a, auquel est associé le signal de validation CEB, voit alors son signal de validation retardé CE-DEL forcé à la valeur de la tension d'alimentation VCC, ce qui a pour effet d'inhiber le processus de tronquage précédemment décrit, les capacités C1, C2, C3 étant continuellement connectées à leurs inverseurs respectifs i1, i2, i3. L'impulsion associée au signal de validation CEB est alors calibrée à la durée souhaitée, établie par la valeur des cellules à retard précédemment mentionnées.

Sur la figure 1b, on indique que les impulsions tronquées et l'impulsion calibrée sont représentées aux points C(1), respectivement C(2) correspondant au cas où le signal de validation CEB étant actif à 0, les transitions sont relatives aux adresses respectivement au signal de validation CEB.

Lors d'un accès par l'intermédiaire du signal de validation CEB et dans le cas de transition d'entrée non simultanée, le décalage entre les autres entrées et le signal de validation CEB peut être au plus égal au retard interne du signal de validation retardé par rapport au signal de validation précité. On évite ainsi la superposition des différentes impulsions engendrées dont la conséquence serait de pénaliser le temps d'accès par l'intermédiaire du signal de validation CEB. La phase de lecture différentielle ne devient effective qu'à la fin de l'impulsion et la durée de cette dernière se trouve augmentée par le cumul des autres impulsions et l'on augmente ainsi le temps d'apparition de la donnée en sortie, la référence étant toujours le front descendant du signal d'entrée correspondant au signal de validation CEB.

On comprend ainsi que grâce au mécanisme précité, des impulsions d'entrée sont inhibées et la calibration nominale de l'impulsion est donnée par le circuit ou dispositif de détection de transition associé au signal de validation CEB.

Dans une variante de réalisation particulièrement avantageuse, telle que représentée en figure 2, on indique que le deuxième circuit de retard 21, circuit de retard commandé, peut comporter en outre une chaîne de charge et de décharge de chaque capacité électrique C1, C2, C3 constituant avec les portes de transfert p1, p2, p3 et les inverseurs associés i1, i2, i3 une cellule de retard élémentaire.

Ainsi qu'on l'observera sur la figure 2, on indique que la chaîne de charge et de décharge comporte, au niveau de chaque cellule de retard, une cellule de charge et de décharge de faible constante de temps. Chaque cellule de charge et de décharge comprend un inverseur de charge et de décharge, noté respectivement I1, I2, I3 connecté à une porte de transfert de charge et de décharge, chacune des portes de transfert de charge et de décharge étant notée P1, P2, P3.

Ainsi qu'on l'observera sur -la figure 2 précitée, chaque porte de transfert de charge et de décharge P1, P2, P3 est connectée entre la sortie de l'inverseur de charge et de décharge qui lui est associée I1, I2, I3 respectivement et la capacité électrique de la cellule de retard correspondante C1, C2 et C3. Les portes de transfert p1, p2, p3 et les portes de transfert de charge et de décharge P1, P2, P3 sont commandées en opposition par le signal de validation retardé complémenté, c'est-à-dire par le signal $\overline{CE\text{-}DEL}$ délivré par l'inverseur d'entrée IE1, et par le signal de validation retardé CE-DEL après double complémentation par les inverseurs d'entrée IE1, IE2.

Le mode de réalisation préférentiel décrit permet d'assurer un passage d'une impulsion tronquée à une impulsion de largeur calibrée, ce passage ou transition étant le plus brutal possible, de façon à éviter les durées d'impulsion intermédiaire dont la conséquence serait une dégradation des performances dynamiques du circuit.

De manière générale, on indique que la zone temporelle critique dans laquelle ce phénomène doit être évité correspond à la fin du retard interne du signal de validation retardé CE-DEL par rapport au signal de validation CEB, fin de la période d'inhibition des impulsions. Une transition d'entrée intervenant à cet instant est suffisamment éloignée de la transition du signal de validation CEB pour être interprétée comme l'initialisation d'un nouveau cycle interne. Il est donc primordial de passer très rapidement d'un état d'impulsion tronquée à un état d'impulsion calibrée sans que ne soient engendrées d'impulsions de durée intermédiaire.

Les conditions précitées sont assurées par le système de charge et de décharge des capacités, contrôlé par le signal d'entrée à mémoriser IN-ETD, lequel est fonction du positionnement de l'adresse et actif pendant la phase d'inhibition. Pendant cette phase, les capacités C1, C2, C3 sont chargées non plus par les inverseurs i1, i2, i3 contrôlant le délai de retard, mais par la chaîne de substitution parallèle formée par les inverseurs I1, I2 et I3, lesquels, de plus grosse taille, autorisent une charge ou une décharge quasi-instantanée. A la fin de la phase d'inhibition, les capacités C1, C2, C3 qui se trouvent donc dans un état favorable, sont reconnectées aux petits inverseurs i1, i2, i3 contrôlant la durée du délai de retard et le traitement de la transition suivante peut alors s'effectuer normalement.

## Revendications

1. Dispositif de détection de transition engendrant une impulsion de durée variable, impulsion telle qu'un signal de validation (CEB) des circuits d'entrée d'un circuit mémoire statique CMOS, ces circuits d'entrée, sur validation, délivrant un signal d'entrée (IN-ETD) à partir d'un signal représentatif d'un signal numérique d'entrée à mémoriser par la mémoire statique, caractérisé en ce que ce dispositif comporte :

   - un premier circuit de retard (1) d'une première valeur de retard déterminée dudit signal de validation (CEB), permettant d'engendrer un signal de validation retardé (CE-DEL), permettant d'introduire un délai de sécurité de durée égale à ladite première valeur de retard,
   - un circuit (2) de calibration dudit signal d'entrée (IN-ETD) comportant :

     . un circuit logique OU exclusif (20) recevant sur une première entrée ledit signal d'entrée (IN-ETD), et
     . un deuxième circuit de retard (21) commandé en durée par le signal de validation retardé (CE-DEL) recevant ledit signal d'entrée (IN-ETD) et délivrant un signal d'entrée retardé d'une deuxième valeur de retard, ledit deuxième circuit de retard commandé (21) étant connecté à une deuxième entrée du circuit logique OU exclusif (20), lequel délivre un signal de sortie calibré (OUT-ETD) formé par une impulsion dont la durée est égale à la deuxième valeur de retard, sur accès par le signal de validation (CEB), et des impulsions tronquées en présence de transitions d'adresses ou d'autres entrées (IN-ETD) non rigoureusement simultanées.

2. Dispositif selon la revendication 1, caractérisé en ce que ledit deuxième circuit de retard commandé (21) est formé par une pluralité de cellules de retard (i1, p1, c1, i2, p2, c2, i3, p3, c3) connectées en cascade, chaque cellule de retard comportant au moins un inverseur (i1, i2, i3) connecté à une porte de transfert (p1, p2, p3), elle-même connectée à une capacité électrique (c1, c2, c3) reliée à la tension de référence, ladite porte de transfert (p1, p2, p3) étant commandée à l'état de conduction ou de non-conduction par ledit signal de validation retardé (CE-DEL), chaque cellule permettant d'introduire sur ledit signal d'entrée (IN-ETD) un retard élémentaire $\tau$ égal à la constante de temps formée par le circuit de charge de ladite capacité électrique (c1, c2, c3), la première cellule de retard (i1, p1, c1) recevant le signal d'entrée complémenté.

3. Dispositif selon l'une des revendications 1 et 2, caractérisé en ce que ledit circuit OU exclusif (20) comporte une première (20a) et une deuxième branche (20b) formée par un transistor MOS N et un transistor MOS P en cascade, les première (20a) et deuxième branches (20b) étant connectées en parallèle entre l'entrée de la première cellule de retard recevant le signal d'entrée complémenté par l'intermédiaire d'un premier inverseur (IE0) et la sortie du circuit d'entrée délivrant le signal d'entrée (ME), l'électrode de grille des transistors MOS N, P de la première branche (20a) étant connectée à la sortie de la dernière cellule de retard par l'intermédiaire d'un deuxième inverseur (IS0), et l'électrode de grille des transistors P, N de la deuxième branche étant connectée à la sortie du deuxième inverseur (IS0) par l'intermédiaire d'un troisième inverseur (IS1), le point commun entre les transistors N et P de la première branche (20a) délivrant par l'intermédiaire d'un quatrième inverseur (IS2) ledit signal de sortie calibré (OUT-ETD).

4. Dispositif selon la revendication 3, caractérisé en ce que chaque porte de transfert (p1, p2, p3) est formée par un premier et un deuxième transistor MOS P, N connectés en parallèle, l'électrode de grille dudit premier transistor MOS P étant commandée par ledit signal de validation retardé complémenté par l'intermédiaire d'un cinquième inverseur (IE1) et l'électrode de grille dudit deuxième transistor MOS N étant commandée par ledit signal de validation retardé.

5. Dispositif selon l'une des revendications 2 à 4, caractérisé en ce que ledit deuxième circuit (21) de retard commandé comporte en outre une chaîne de charge et de décharge de chaque capacité électrique (c1, c2, c3) constituant une cellule de retard élémentaire, ladite chaîne de charge et de décharge comportant au niveau de chaque cellule de retard, une cellule de charge et de décharge, de faible constante de temps, chaque cellule de charge et de décharge comprenant un inverseur de charge et de décharge (I1, I2, I3) connecté à une porte de transfert de charge et de décharge (P1, P2, P3), chaque porte de transfert de charge et de décharge (P1, P2, P3) étant connectée entre la sortie de l'inverseur de charge et de décharge qui lui est associé (I1, I2, I3) et la capacité électrique (C1, C2, C3) de la cellule de retard correspondante, les porte de transfert (p1, p2, p3) et porte de transfert de charge et de décharge (P1, P2, P3) étant commandées en opposition par ledit signal de validation retardé complémenté et par ledit signal de validation retardé (CE-DEL).

6. Utilisation d'un dispositif de détection de transition selon l'une des revendications précédentes, pour le contrôle d'accès à une mémoire statique de mots codés sur N bits, un dispositif de détection étant associé à l'accès de chaque bit à la mémoire statique.

**Patentansprüche**

1. Übergangserfassungsvorrichtung zur Erzeugung eines Pulses mit variabler Dauer, wobei der Puls beispielsweise ein Freigabesignal (CEB) für Eingangsschaltkreise eines statischen Speicherschaltkreises (CMOS) ist, wobei diese Eingangsschaltkreise bei Freigabe ein Eingangssignal (IN-ETD) ausgehend von einem Signal liefern, welches für ein durch den statischen Speicher zu speicherndes digitales Eingangssignal repräsentativ ist, dadurch gekennzeichnet, daß die Vorrichtung umfaßt:

   - einen ersten Schaltkreis zur Verzögerung (1) des Freigabesignals (CEB) um einen ersten bestimmten Verzögerungswert, was die Erzeugung eines verzögerten Freigabesignals (CE-DEL) erlaubt, was das Einfügen einer Sicherheitsverzögerung erlaubt, deren Dauer gleich dem ersten Verzögerungswert ist,
   - einen Schaltkreis (2) zur Eichung des Eingangssignals (IN-ETD), umfassend:

      · einen Exklusives-ODER-Logikschaltkreis (20), der an einem ersten Eingang das Eingangssignal (IN-ETD) empfängt, und
      · einen zweiten Verzögerungsschaltkreis (21) mit einer durch das verzögerte Freigabesignal (CE-DEL) gesteuerten Dauer, der das Eingangssignal (IN-ETD) empfängt und ein um einen zweiten Verzögerungswert verzögertes Eingangssignal liefert, wobei der zweite Schaltkreis zur gesteuerten Verzögerung (21) an einen zweiten Eingang des Exklusives-ODER-Logikschaltkreises (20) angeschlossen ist, welcher bei Zugriff durch das Freigabesignal (CEB) ein geeichtes Ausgangssignal (OUT-ETD) liefert, das durch einen Puls gebildet ist, dessen Dauer gleich dem zweiten Verzögerungswert ist, sowie in Anwesenheit von Adressenübergängen oder anderen nicht streng simultanen Eingaben (IN-ETD) abgeschnittene Pulse liefert.

2. Vorrichtung nach Anspruch 1, dadurch gekennzeichnet, daß der zweite Schaltkreis zur gesteuerten Verzögerung (21) durch eine Mehrzahl von in Kaskade verbundenen Verzögerungszellen (i1, p1, c1, i2, p2, c2, i3, p3, c3) gebildet ist, wobei jede Verzögerungszelle wenigstens einen Inverter (i1, i2, i3) umfaßt, der an ein Übertragungsglied (p1, p2, p3) angeschlossen ist, welches selbst wiederum an eine mit der Bezugsspannung verbundene elektrische Kapazität (c1, c2, c3) angeschlossen ist, wobei das Übertragungsglied (p1, p2, p3) durch das verzögerte Freigabesignal (CE-DEL) in den Leitungs- oder Nichtleitungszustand gesteuert wird, wobei jede Zelle das Einfügen einer Elementarverzögerung r in das Eingangssignal (IN-ETD) erlaubt, welche gleich der durch den Ladeschaltkreis der elektrischen Kapazität (c1, c2, c3) gebildeten Zeitkonstante ist, wobei die erste Verzögerungszelle (i1, p1, c1) das komplementierte Eingangssignal erhält.

3. Vorrichtung nach einem der Ansprüche 1 und 2, dadurch gekennzeichnet, daß der Exklusives-ODER-Schaltkreis (20) einen durch einen N-MOS-Transistor und einen P-MOS-Transistor in Kaskade gebildeten ersten (20a) und zweiten (20b) Zweig umfaßt, wobei der erste (20a) und der zweite (20b) Zweig parallel angeschlossen sind zwischen dem Eingang der ersten Verzögerungszelle, die das komplementierte Eingangssignal mittels eines ersten Inverters (IE0) empfängt, und dem Ausgang des das Eingangssignal (ME) liefernden Eingangsschaltkreises, wobei die Steuerelektrode der N- und P-MOS-Transistoren des ersten Zweigs (20a) an den Ausgang der letzten Verzögerungszelle mittels eines zweiten Inverters (IS0) angeschlossen sind, und wobei die Steuerelektrode der P- und N-Transistoren des zweiten Zweigs an den Ausgang des zweiten Inverters (IS0) mittels eines dritten Inverters (IS1) angeschlossen sind, wobei der gemeinsame Punkt zwischen den N- und P-Transistoren des ersten Zweigs (20a) mittels eines vierten Inverters (IS2) das geeichte Ausgangssignal (OUT-EDT) liefert.

4. Vorrichtung nach Anspruch 3, dadurch gekennzeichnet, daß jedes Übertragungsglied (p1, p2, p3) durch einen ersten und einen zweiten P-, N-MOS-Transistor gebildet ist, die parallel angeschlossen sind, wobei die Steuerelektrode des ersten P-MOS-Transistors durch das verzögerte Freigabesignal gesteuert ist, welches mittels eines fünften Inverters (IE1) komplementiert ist, und wobei die Steuerelektrode des zweiten N-MOS-Transistors durch das verzögerte Freigabesignal gesteuert ist.

5. Vorrichtung nach einem der Ansprüche 2 bis 4, dadurch gekennzeichnet, daß der zweite Schaltkreis (21) zur gesteuerten Verzögerung ferner eine Lade- und Entladekette für jede eine Elementarverzögerungszelle bildende elektrische Kapazität (c1, c2, c3) umfaßt, wobei die Lade- und Entladekette im Bereich jeder Verzögerungszelle eine Lade- und Entladezelle mit niedriger Zeitkonstante enthält, wobei jede Lade- und Entladezelle einen Lade- und Entladeinverter (I1, I2, I3) enthält, der an ein Lade- und Entladeübertragungsglied (P1, P2, P3) angeschlossen ist, wobei jedes Lade- und Entladeübertragungsglied (P1, P2, P3) zwischen dem Ausgang des ihm zugeordneten Lade- und Entladeinverters (I1, I2, I3) und der elektrischen Kapazität (C1, C2, C3) der entsprechenden Verzögerungszelle angeschlossen ist, wobei die Übertragungsglieder (p1, p2, p3) und die Lade- und Entladeübertragungsglieder (P1, P2, P3) durch das komplementierte verzögerte Freigabesignal und durch das verzögerte Freigabesignal (CE-DEL) entgegengesetzt gesteuert sind.

6. Verwendung einer Übergangserfassungsvorrichtung nach einem der vorhergehenden Ansprüche zur Steuerung des Zugriffs auf einen statischen Speicher mit codierten Worten mit N Bits, wobei eine Erfassungsvorrichtung dem Zugriff jedes Bits auf den statischen Speicher zugeordnet ist.

**Claims**

1. A transition detection device generating a variable-duration pulse, such as an enable signal (CEB) for the input circuits of a CMOS static memory circuit, these input circuits, on being enabled, delivering an input signal from the signal representing an input digital signal to be stored by the static memory, said transition detection device being characterized by including:

 - a first circuit (1) for delaying said enable signal (CEB) by a first determined delay value, making it possible to generate a delayed enable signal (CE-DEL), making it possible to introduce a safety margin of duration equal to said first delay value,

 - a circuit (2) for calibration of said input signal (IN-ETD) including:

 . an exclusive-OR logic circuit (20) receiving said input signal (IN-ETD) on a first input, and
 . a second controlled delay circuit (21) controlled in duration by said delayed enable signal (CE-DEL) and receiving said input signal, said second controlled delay circuit (21) receiving said input signal (IN-ETD) and delivering an input signal delayed by a second delay value, said second controlled delay circuit (21) being connected to a second input of the exclusive-OR logic circuit (20), which delivers a calibrated output signal (OUT-ETD) formed by a pulse the duration of which is equal to the second delay value upon access by the enable signal (CEB) and truncated pulses in the presence of address transitions or of not strictly simultaneous other inputs (IN-ETD).

2. Device according to Claim 1, characterized by said second controlled delay circuit (21) being formed by a plurality of delay cells (i1, p1, c1, i2, p2, c2, i3, p3, c3) connected in cascade, each delay cell including at least:
an inverter (i1, i2, i3) connected to a transfer gate (p1, p2, p3), itself connected to an electrical capacitor (c1, c2, c3) linked to the reference voltage, said transfer gate (p1, p2, p3) being driven to the conducting or non-conducting state by said delayed enable signal (CE-DEL), each cell making it possible to introduce, onto said input signal (IN-ETD), an elementary delay T equal to the time constant formed by the circuit for charging said electrical capacitor, the first delay cell (i1, p1, c1) of said plurality of delay cells receiving complemented input signal.

3. Device according to one of the Claims 1 or 2, characterized by said exclusive-OR circuit (20) including a first (20a) and a second branch (20b) formed by an N MOS transistor and a P MOS transistor in cascade, the first (20a) and second branches (20b) being connected in parallel between the input of the first delay cell receiving the complemented input signal via a first inverter (IE0) and the output of the input circuit delivering the input signal (ME), the gate electrode of the N, P MOS transistors of the first branch (20a) being connected to the output of the last delay cell via a second inverter (IS0), and the gate electrode of the P, N transistors of the second branch being connected to the output of the second inverter (IS0) via a third inverter (IS1), the common point between the N and P transistors of the first branch (20a) delivering the said calibrated output signal (OUT-ETD) via a fourth inverter (IS2).

4. Device according to Claim 3, characcerized by each transfer gate (p1, p2, p3) being formed by a first and a second P, N MOS transistor which are connected in parallel, the gate electrode of said first P MOS transistor being driven by said complemented delayed enable signal aria a fifth inverter (IE1) and the gate electrode of said second N MOS transistor being driven by said delayed enable signal.

5. Device according to one of the Claims 2 to 4, characterized by said second controlled delay circuit (21) further including a chain for charging and discharging each electrical capacitor (c1, c2, c3) constituting an elementary delay cell, said charging and discharging chain, within each delay cell, including a charging and discharging cell, of short time constant, each charging and discharging cell comprising a charging and discharging inverter (I1, I2, 13) connected to a charging and discharging transfer gate (P1, P2, P3), each charging and discharging transfer gate (P1, P2, P3) being connected between the output of the charging and discharging inverter (I1, 12, I3) which is associated with it and the electrical capacitor (C1, C2, C3) of the corresponding delay cell, the transfer gate (p1, p2, p3) and charging and discharging transfer gate (P1, P2, P3) being driven in opposition by said complemented delayed enable signal and by said delayed enable signal (CE-DEL).

6. Utilization of a transition detection device according to one of the preceding claims, for controlling access to a static memory of words coded over N bits, with one transition detection device being associated to the bit access to this static memory.

# FIG.1a.

# FIG.1b.

FIG.2.

EP 0 685 848 B1